# DEMANDE DE BREVET EUROPEEN

(11) **EP 0 858 107 A1**
(43) Date de publication de la demande: **12.08.1998**
(21) Numéro de dépôt: 98420019.6
(22) Date de dépôt: 30.01.1998
(51) Int. Cl.: H01L 23/473, H05K 7/20

(54) **Echangeur de chaleur pour composants électroniques et appareillages électrotechniques**

(30) Priorité: 03.02.1997 FR 9701384
(71) Demandeur: FERRAZ, 69003 Lyon (FR)
(72) Inventeur: Chevallet, Jean-Luc, 38080 L'Ile D'Abeau (FR); Rubichon, Ivan, 38160 Saint Marcellin (FR); Marichy, Gérard, 69110 Sainte Foy Les Lyon (FR)
(74) Mandataire: Myon, Gérard Jean-Pierre

(57) **Abrégé**

Echangeur de chaleur pour composants électroniques et appareillages électrotechniques comprenant un boîtier (5) définissant un espace intérieur parcouru par un fluide caloporteur, au moins une face dudit boîtier orientée vers lesdits composants ou appareillages étant recouverte d'une plaque (6, 7) d'isolation électrique, caractérisé en ce que ledit boîtier et ladite plaque sont surmoulés dans un revêtement (2) en un matériau électriquement isolant et en ce qu'une entretoise (10, 10', 11, 11') de dilatation est disposée entre le boîtier et ladite plaque d'isolation.

## Description

L'invention a trait à un échangeur de chaleur pour composants électroniques et appareillages électrotechniques. Les échangeurs de ce type peuvent être utilisés dans des ensembles de puissance afin de refroidir les composants grâce à la circulation d'un fluide tel que de l'eau.

Du fait de leur fonctionnement, les composants électriques ou électroniques peuvent être portés à un potentiel sensiblement différent de celui de la terre, de l'ordre de plusieurs kilovolts, alors que les échangeurs de chaleur qui sont métalliques doivent demeurer au potentiel de la terre, en particulier du fait qu'ils contiennent un liquide conducteur qui doit être à ce potentiel. En effet, les canalisations de circulation du fluide de refroidissement peuvent être touchées par un opérateur, de sorte qu'il est impératif qu'elles ne soient pas à la haute tension. De plus, ce liquide circule entre des composants qui peuvent être à des potentiels électriques différents.

Pour isoler électriquement un échangeur de chaleur d'un composant électrique porté à la haute tension, il est connu d'insérer entre ces deux éléments une plaque d'isolation en céramique, par exemple en alumine ou en nitrure d'aluminium. La forme de cette plaque est adaptée à la surface de l'échangeur en regard des composants. Pour éviter un courant de cheminement, résultant de la haute tension, du composant vers l'échangeur de chaleur, on choisit le plus souvent d'utiliser une plaque d'isolation dont les dimensions sont sensiblement supérieures à celles du composant et de l'échangeur afin d'allonger le plus possible le cheminement. Ceci augmente les dimensions transversales de l'échangeur. De plus, l'utilisation d'une telle plaque nécessite des opérations précises lors de sa mise en place, ce qui rend plus complexe l'installation de systèmes incorporant de tels échangeurs de chaleur. En outre, ces plaques d'isolation sont fragiles et peuvent être brisées lors de leur mise en place ou lors de la mise en pression d'un système composé de plusieurs composants et de plusieurs échangeurs de chaleur disposés en alternance.

On pourrait envisager de recouvrir un échangeur de chaleur du type précité d'un revêtement isolant électrique de façon à éviter le plus possible le cheminement de l'électricité. Dans ce cas et comme cela apparaît à la figure 5 du dessin annexé aux présentes, le boîtier central 105 d'un échangeur de chaleur 101 et une plaque d'isolation électrique 106 seraient recouverts, par exemple par surmoulage, par un revêtement 102. Or, ces éléments sont susceptibles de fonctionner dans une plage de températures relativement large, car la température de l'eau utilisée pour le refroidissement peut évoluer entre 5 et environ 100°C alors que cet élément est soumis à une pression pouvant atteindre 5 tonnes au décimètre carré. L'échangeur de chaleur est classiquement réalisé en métal alors que la couche d'isolation électrique est réalisée dans un matériau d'isolation non métallique. L'échangeur et la plaque ont donc des coefficients de dilatation sensiblement différents, de sorte qu'à cause des variations des températures auxquelles ils sont soumis, leurs variations dimensionnelles sont sensiblement différentes.

Or, dans le cas représenté à la figure 5, aucun glissement ne serait admissible car la zone de contact 120 entre le boîtier 105 et d'une part la plaque 106, d'autre part le revêtement 102, constituerait une succession de points d'ancrage ou d'adhérence des deux éléments 105 et 106 dans le revêtement 102. Compte tenu des dilatations différentielles obtenues, on obtiendrait donc des fissures dans le matériau le plus fragile, c'est-à-dire dans la plaque d'isolation électrique. Ces fissures serviraient de cheminement électrique, de sorte que la plaque ne serait plus en mesure de remplir efficacement son rôle d'isolation. Jusqu'à présent, on a donc été dissuadé de réaliser un échangeur de chaleur du type considéré, noyé dans un revêtement en matériau électriquement isolant. On doit donc se contenter des systèmes avec plaque d'isolation rapportée, avec les inconvénients précités.

C'est à ces inconvénients qu'entend remédier l'invention en proposant un échangeur de chaleur susceptible de fonctionner dans une large plage de températures, malgré les dilatations différentielles obtenues dans les différents matériaux, tout en étant électriquement isolé par rapport aux matériels électriques qui l'entourent.

Dans cet esprit, l'invention concerne un échangeur de chaleur pour composants électroniques et appareillages électrotechniques, comprenant un boîtier définissant un espace intérieur parcouru par un fluide caloporteur, au moins une face dudit boîtier orientée vers lesdits composants ou appareillages étant recouverte d'une plaque d'isolation électrique, caractérisé en ce que ledit boîtier et ladite plaque sont surmoulés dans un revêtement en un matériau électriquement isolant et en ce qu'une entretoise de dilatation est disposée entre ledit boîtier et ladite plaque d'isolation.

Grâce à l'invention, les dilatations différentielles inhérentes à l'utilisation de l'échangeur de chaleur ne conduisent pas à la destruction de celui-ci, en particulier de la plaque d'isolation électrique, car l'entretoise de dilatation permet un déplacement relatif de la plaque d'isolation par rapport au boîtier de l'échangeur.

Selon une forme de réalisation de l'invention, un flasque de protection est placé sur la face externe de la plaque d'isolation, une entretoise de dilatation étant disposée entre le flasque et la plaque. Comme précédemment indiqué, l'entretoise de dilatation permet de compenser les dilatations différentielles existant entre le flasque qui, en pratique, est métallique et la plaque d'isolation qui ne l'est pas.

Selon un aspect particulièrement avantageux de l'invention et quel que soit le mode de réalisation choisi, le bord périphérique de l'entretoise est en retrait par rapport au bord périphérique correspondant de la plaque d'isolation, du boîtier ou du flasque. Cette construction permet de protéger l'entretoise de dilatation par la plaque d'isolation ou le flasque. Ceci permet aussi de rallonger le cheminement des charges électrostatiques autour de la plaque d'isolation.

Dans ce cas et selon un autre aspect avantageux de l'invention, on peut prévoir que l'espace libre ménagé au voisinage du bord périphérique de l'entretoise entre la plaque d'isolation et le boîtier ou entre la plaque d'isolation et le flasque de protection, est globalement rempli du matériau électriquement isolant formant le revêtement. Ce remplissage de l'espace laissé libre par l'entretoise de dilatation permet au matériau d'isolation d'absorber les variations dimensionnelles en se déformant à cause de son élasticité naturelle.

Selon une construction particulièrement avantageuse, le revêtement isolant comprend des langues pénétrant entre ladite plaque et ledit boîtier ou ledit flasque jusqu'au voisinage du bord périphérique de ladite entretoise de dilatation. Ces langues rallongent le cheminement de la haute tension.

Selon des choix de réalisation, on peut prévoir que l'entretoise de dilatation est réalisée dans une feuille métallique, par métallisation de la plaque d'isolation ou par engobage, c'est-à-dire suspension dense d'une poudre réfractaire ou métallique dans un liant, notamment suspension de poudre de carbone dans une résine organique. L'entretoise peut également être réalisée dans une feuille de graphite souple. Dans ce dernier cas, cette feuille peut avoir une épaisseur comprise entre 0 et 1 mm, de préférence entre 0,2 et 0,5 mm. D'autres matériaux peuvent être adoptés pour la fabrication de l'entretoise de dilatation pour autant que la combinaison de leurs caractéristiques physiques, telle que leur module d'élasticité longitudinale, leur coefficient de dilatation thermique, leur coefficient de frottement par rapport à la plaque d'isolation et leur conductivité thermique, sont compatibles avec l'objectif précité. Par ailleurs, l'épaisseur de l'entretoise est choisie en fonction de ces caractéristiques.

Quel que soit le mode de réalisation choisi, le revêtement en matériau électriquement isolant peut comprendre des soufflets disposés autour des tubulures d'entrée et de sortie de l'échangeur. Ces soufflets ont pour fonction de rallonger le cheminement des charges électriques.

L'invention sera mieux comprise et d'autres avantages de celle-ci apparaîtront plus clairement à la lumière de la description qui va suivre de deux modes de réalisation d'un échangeur de chaleur conformes à son principe, donnée uniquement à titre d'exemple et faite en référence aux dessins annexés dans lesquels :
- la figure 1 est une vue en perspective d'un échangeur de chaleur conforme à l'invention ;
- la figure 2 est une coupe à plus grande échelle selon la ligne II-II à la figure 1 ;
- la figure 3 est une vue de détail à plus grande échelle de la zone indiquée III à la figure 2 ;
- la figure 4 est une vue analogue à la figure 3 pour un échangeur de chaleur conforme à un second mode de réalisation de l'invention et
- la figure 5 est une vue analogue à la figure 3 pour un échangeur de chaleur n'incorporant pas l'invention.

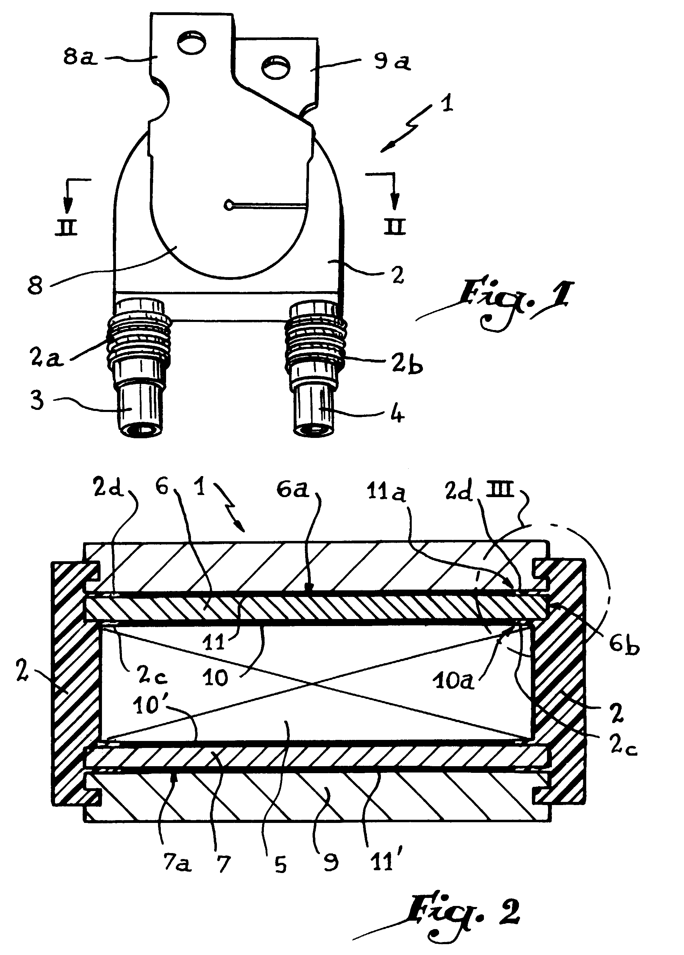

A la figure 1, un échangeur de chaleur 1 est pourvu d'un revêtement 2 en matériau électriquement isolant tel que notamment en élastomère naturel ou à base de silicone, en résine ou en tout autre matériau présentant des propriétés d'isolation adaptées. Deux tubulures métalliques 3 et 4 servent à l'alimentation et à l'évacuation d'un fluide caloporteur à l'intérieur de l'échangeur. Le revêtement 2 comprend des soufflets 2a et 2b disposés autour des tubulures 3 et 4 qui sont au potentiel de la terre. Ces soufflets ont pour fonction de rallonger le cheminement des charges électriques entre les surfaces de l'échangeur destinées à être en contact avec des composants électroniques ou des appareillages électrotechniques et les tubulures 3 et 4.

Comme il apparaît plus clairement à la figure 2, le boîtier 5 central de l'échangeur de chaleur, qui peut être réalisé en aluminium et conforme à l'enseignement technique de EP-A-0 611 235, est surmoulé dans le revêtement 2 avec deux plaques 6 et 7 d'isolation électrique et deux flasques 8 et 9 assurant la protection mécanique des plaques 6 et 7 et la conduction thermique entre le boîtier 5 et les composants électriques voisins, ainsi que, dans certains cas, une connexion électrique avec une source de potentiel. Les flasques 8 et 9 sont placés au voisinage de la face externe 6a ou 7a des plaques 6 et 7 et portent des extensions 8a et 9a permettant leur raccordement sur une barre de maintien ou leur connexion électrique. Ainsi, l'échangeur 1 constitue un ensemble monobloc qui peut être manipulé de façon simple et dont les plaques d'isolation 6 et 7 ne risquent pas d'être endommagées en cours de manipulation. Les plaques 6 et 7 peuvent être réalisées en alumine (Al₂O₃), ou nitrure d'aluminium ou en toute autre céramique adaptée.

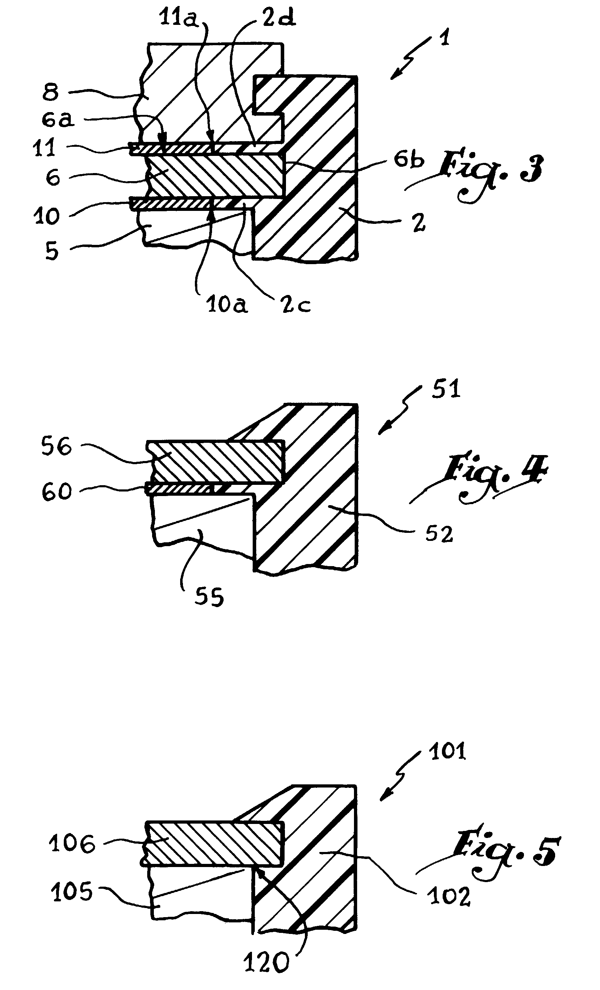

Comme il apparaît plus clairement à la figure 3, une entretoise de dilatation 10 est disposée entre le boîtier 5 et la plaque 6 alors qu'une entretoise de dilatation analogue 11 est disposée entre la plaque 6 et le flasque 8. Des entretoises identiques 10' et 11' sont disposées de part et d'autre de la plaque 7.

Les entretoises 10 et 11 sont réalisées dans une feuille de graphite souple commercialisée par la société CARBONE LORRAINE sous la marque PAPYEX (marque déposée). Les entretoises 10 et 11 ont une épaisseur comprise entre 0,1 et 1 mm. En pratique, une épaisseur comprise entre 0,2 et 0,5 mm est suffisante pour remplir la fonction recherchée. Le caractère souple du graphite utilisé pour les entretoises 10 et 11 lui permet avantageusement de compenser de légères variations de cotes ou des irrégularités de surface de l'échangeur 1 sans que celles-ci ne risquent d'endommager la plaque 6.

Le graphite souple a un faible coefficient de frottement avec le métal du boîtier 5 et avec l'alumine de la plaque 6, de sorte qu'un glissement relatif de ces deux éléments est possible, en particulier par suite des dilatations différentielles obtenues en cas d'augmentation sensible de la température de l'ensemble de l'échangeur 1. On note qu'il n'existe pas de zone d'adhérence telle que la zone 120 représentée à la figure 5, car le boîtier 1 et la plaque 6 ne sont pas en contact direct.

De la même manière, l'entretoise 11 permet un déplacement relatif de la plaque 6 et du flasque 8.

Le bord périphérique 10a de l'entretoise 10 et le bord périphérique 11a de l'entretoise 11 sont en retrait à l'intérieur du volume occupée par les entretoises 10 et 11 de part et d'autre de la plaque 6. En d'autres termes et comme montré en figure 3, ces bords 10a et 11a sont en retrait par rapport aux bords correspondants du boîtier 5, de la plaque 6 et du flasque 8. Deux langues 2c et 2d de matériau isolant pénètrent ainsi, au cours du surmoulage, à l'intérieur de l'espace laissé libre par les entretoises 10 et 11 au voisinage du bord périphérique 6b de la plaque 6 jusqu'à proximité des bords 10a et 11a des entretoises 10 et 11. Ces langues 2c et 2d rallongent le cheminement de l'électricité au voisinage de la plaque 6, de sorte que celle-ci est efficace même si son diamètre n'est pas sensiblement supérieur à celui du boîtier 5 et du flasque 8. Ce gain résulte de la bonne adhérence du matériau constituant le revêtement 2 sur la plaque d'isolation 6 jusqu'au voisinage immédiat des entretoises 10 et 11, ce qui permet de limiter la circulation des charges électriques à la surface de la plaque 6 et de renforcer son efficacité. Ceci permet de réduire les dimensions transversales de l'échangeur de l'invention, et donc son encombrement.

Dans le second mode de réalisation de l'invention représenté à la figure 4, les éléments analogues à ceux du mode de réalisation des figures 1 à 3 portent des références identiques augmentées de 50. L'échangeur 51 de ce mode de réalisation diffère du précédent essentiellement en ce qu'il ne comprend pas de flasque de protection. Dans ce cas, la plaque d'isolation 56 et le boîtier 55 de l'échangeur sont surmoulés dans un revêtement 52 formé, par exemple, de résine polymérisée. Une entretoise de dilatation 60 est disposée entre la plaque 56 et le boîtier 55 et permet un déplacement transversal de ces éléments en fonction des dilatations différentielles résultant des contraintes thermiques. L'entretoise 60 est réalisée en aluminium et a une épaisseur comprise entre 0,1 et 1 mm, de préférence entre 0,1 et 0,5 mm.

L'entretoise 60 pourrait également être réalisée dans d'autres matériaux, choisis notamment en fonction de leur coefficient de friction avec le boîtier 55 et la plaque 56. A titre d'exemple, on peut utiliser du cuivre, de l'argent, de l'or, de l'alumine ou des fibres de carbone.

Ce mode de réalisation de l'invention présente, par rapport au précédent, l'avantage d'être plus facile à mettre en oeuvre dans la mesure où un seul joint doit être disposé de part et d'autre du boîtier 55, en favorisant les échanges thermiques entre le boîtier 55 et les composants auxquels il est accolé. Des précautions particulières doivent cependant être prises pour ne pas endommager la plaque 56 qui est exposée au cours des manipulations.

Selon d'autres variantes non représentées de l'invention, l'entretoise de dilatation peut être réalisée par métallisation de la plaque d'isolation 6 ou 56. Il est aussi concevable de disposer entre les éléments 5 et 6, 6 et 8 ou 55 et 56 un joint réalisé à partir d'un métal liquide tel que notamment commercialisé sous la marque déposée CRAYOFOIL.

Quel que soit le mode de réalisation choisi, l'échangeur de chaleur obtenu est efficacement protégé contre les cheminements de courant alors qu'il est apte à supporter des variations de température importantes.

L'invention a été représentée avec un boîtier de forme globalement cylindrique à section circulaire mais elle est applicable quelle que soit la forme de ce boîtier.

## Revendications

1. Echangeur de chaleur (1, 51) pour composants électroniques et appareillages électrotechniques, comprenant un boîtier (5, 55) définissant un espace intérieur parcouru par un fluide caloporteur, au moins une face dudit boîtier orientée vers lesdits composants ou appareillages étant recouverte d'une plaque (6, 7, 56) d'isolation électrique, caractérisé en ce que ledit boîtier et ladite plaque sont surmoulés dans un revêtement (2, 52) en un matériau électriquement isolant et en ce qu'une entretoise de dilatation (10, 10', 60) est disposée entre le boîtier et ladite plaque d'isolation.

2. Echangeur de chaleur selon la revendication 1, caractérisé en ce qu'un flasque (8, 9) de protection est placé sur la face externe de ladite plaque d'isolation, une entretoise de dilatation (11, 11') étant disposée entre ledit flasque et ladite plaque (6, 7).

3. Echangeur de chaleur selon la revendication 1 ou 2, caractérisé en ce que le bord périphérique (10a, 11a) de ladite entretoise (10, 11, 60) est en retrait par rapport au bord périphérique (6b) correspondant de ladite plaque d'isolation (6, 56), dudit boîtier (5, 55) ou dudit flasque (8).

4. Echangeur de chaleur selon la revendication 3, caractérisé en ce que l'espace libre ménagé au voisinage dudit bord périphérique (10a, 11a) de ladite entretoise (10, 11, 60) entre ladite plaque (6, 56) d'isolation et ledit boîtier (5, 55) ou entre ladite plaque d'isolation et ledit flasque (8), est globalement rempli du matériau électriquement isolant formant ledit revêtement (2, 52).

5. Echangeur de chaleur selon la revendication 4, caractérisé en ce que ledit revêtement isolant (2, 52) comprend des langues (2c, 2d) pénétrant entre ladite plaque (6, 56) et ledit boîtier (5, 55) ou ledit flasque (8) jusqu'au voisinage du bord périphérique (10a, 11a) de ladite entretoise de dilatation (10, 11, 60).

6. Echangeur de chaleur selon la revendication 1, caractérisé en ce que ladite entretoise de dilatation (60) est réalisée dans une feuille métallique.

7. Echangeur de chaleur selon la revendication 1, caractérisé en ce que ladite entretoise de dilatation est réalisée par métallisation de ladite plaque d'isolation.

8. Echangeur de chaleur selon la revendication 1, caractérisé en ce que ladite entretoise de dilatation (10, 10', 11, 11') est réalisée par une feuille de graphite souple.

9. Echangeur de chaleur selon la revendication 8, caractérisé en ce que ladite feuille de graphite souple présente une épaisseur comprise entre 0,1 et 1 mm, de préférence entre 0,2 et 0,5 mm.

10. Echangeur de chaleur selon la revendication 1, caractérisé en ce que ledit revêtement (2) en matériau électriquement isolant comprend des soufflets (2a, 2b) disposés autour des tubulures (3, 4) d'entrée et de sortie dudit échangeur (1).
